# EUROPEAN PATENT SPECIFICATION

(11) **EP 3 221 085 B1**
(45) Date of publication and mention of the grant of the patent: **29.05.2024**
(21) Application number: 15808296.6
(22) Date of filing: 12.11.2015
(51) Int. Cl.: B24B 37/22, B24B 37/24

(54) **COATED COMPRESSIVE SUBPAD FOR CHEMICAL MECHANICAL POLISHING**
BESCHICHTETES DRUCKUNTERKISSEN ZUM CHEMISCH-MECHANISCHEN POLIEREN
SOUS-TAMPON COMPRESSIF REVÊTU POUR POLISSAGE CHIMICO-MÉCANIQUE

(30) Priority: 21.11.2014 US 201462083101 P; 02.03.2015 US 201514635973
(43) Date of publication of application: 27.09.2017
(73) Proprietor: CMC Materials LLC, Wilmington, DE 19801 (US)
(72) Inventor: SCOTT, Diane, Portland, Oregon 97212 (US); LEFEVRE, Paul Andre, Portland, Oregon 97124 (US)
(74) Representative: Barker Brettell LLP
(86) International application number: PCT/US2015/060343
(87) International publication number: WO 2016/081272

(56) References cited:
- EP-A1- 1 588 802
- WO-A1-01/53042
- WO-A2-02/02274
- US-A1- 2008 274 674
- US-A1- 2013 012 107

## Description

### TECHNICAL FIELD

Embodiments of the present invention are in the field of chemical mechanical polishing (CMP) and, in particular, coated compressive subpads for polishing pad stacks and methods of fabricating coated compressive subpads for polishing pad stacks.

### BACKGROUND

Chemical-mechanical planarization or chemical-mechanical polishing, commonly abbreviated CMP, is a technique used in semiconductor fabrication for planarizing a semiconductor wafer or other substrate.

The process uses an abrasive and/or corrosive chemical slurry (commonly a colloid) in conjunction with a polishing pad and retaining ring, typically of a greater diameter than the wafer. The polishing pad and wafer are pressed together by a dynamic polishing head and held in place by a plastic retaining ring. The dynamic polishing head is rotated during polishing. This approach aids in removal of material and tends to even out any irregular topography, making the wafer flat or planar. This may be necessary in order to set up the wafer for the formation of additional circuit elements. For example, this might be necessary in order to bring the entire surface within the depth of field of a photolithography system, or to selectively remove material based on its position. Typical depth-of-field requirements are down to Angstrom levels for the latest sub-50 nanometer technology nodes.

The process of material removal is not simply that of abrasive scraping, like sandpaper on wood. The chemicals in the slurry also react with and/or weaken the material to be removed. The abrasive accelerates this weakening process and the polishing pad helps to wipe the reacted materials from the surface. In addition to advances in slurry technology, the polishing pad plays a significant role in increasingly complex CMP operations.

However, additional improvements are needed in the evolution of CMP pad technology,

From WO 01/53042 A1 there is known a polishing pad stack according to the preamble of claim 1, a method of fabricating a polishing pad stack according to the preamble of claim 9 and a subpad for a polishing pad stack according to the preamble of claim 14.

### SUMMARY

Embodiments of the present invention include coated compressive subpads for polishing pad stacks and methods of fabricating coated compressive subpads for polishing pad stacks.

The embodiments of the invention are defined by the independent claims. Preferred embodiments are defined by the dependent claims.

### BRIEF DESCRIPTION OF THE DRAWINGS

Figure 1 illustrates a cross-sectional view of a state of the art polishing pad and subpad pairing.
Figure 2 illustrates a cross-sectional view of a polishing pad and subpad pairing, in accordance with an embodiment of the present invention.
Figure 3A is cross-sectional scanning electron microscope (SEM) image of an exemplary compressive foam subpad, in accordance with an embodiment of the present invention.
Figure 3B is cross-sectional scanning electron microscope (SEM) image of another exemplary compressive foam subpad, in accordance with another embodiment of the present invention.
Figure 4A illustrates a cross-sectional view of a state of the art subpad having an adhesive film laminated thereon.
Figure 4B illustrates a cross-sectional view of a subpad having a pressure sensitive adhesive layer coated thereon, in accordance with an embodiment of the present invention.
Figure 5 illustrates a cross-sectional view of a polishing pad and subpad pairing where the polishing pad includes a polishing layer and a foundation layer, in accordance with an embodiment of the present invention.
Figure 6 illustrates a state of the art four step lamination pass pad/subpad fabrication process.
Figure 7 illustrates a subpad fabrication process involving coating of pressure sensitive adhesive layers onto the subpad material, in accordance with an embodiment of the present invention.
Figure 8 illustrates coating of a pressure sensitive adhesive layer onto a subpad material using a Meyer bar, in accordance with an embodiment of the present invention.
Figure 9 illustrates an apparatus for performing a Corona discharge treatment of a compressive foam subpad surface prior to coating an adhesive layer thereon, in accordance with an embodiment of the present invention.
Figure 10 illustrates an isometric side-on view of a polishing apparatus compatible with a polishing pad/subpad polishing pad stack, in accordance with an embodiment of the present invention.

### DETAILED DESCRIPTION

Coated compressive subpads for polishing pad stacks and methods of fabricating coated compressive subpads for polishing pad stacks are described herein. In the following description, numerous specific details are set forth, such as specific polishing pad and subpad compositions and designs, in order to provide a thorough understanding of embodiments of the present invention. It will be apparent to one skilled in the art that embodiments of the present invention may be practiced without these specific details. In other instances, well-known processing techniques, such as details concerning the combination of a slurry with a polishing pad to perform CMP of a semiconductor substrate, are not described in detail in order to not unnecessarily obscure embodiments of the present invention. Furthermore, it is to be understood that the various embodiments shown in the figures are illustrative representations and are not necessarily drawn to scale.

Polishing pads for CMP operations may have trade-offs in performance such as a trade-off between across-wafer polishing uniformity versus within die polishing uniformity. For example, hard polishing pads may exhibit good die-level planarization, but poor across-wafer uniformity. A compressible subpad can be included with a polishing pad or layer to improve the global non-uniformity performance of the overlying polishing pad or layer.

In accordance with one or more embodiments herein, double coated subpads are described, such as double coated foam subpads. For example, an adhesive coated foam can be used as a foundation (subpad) layer for CMP polishing pads. The adhesive coated foam may be made using one or combination of the following features: (1) the adhesive may be directly coated onto one surface of the subpad material, (2) the adhesive can be directly coated onto both surfaces of the subpad material, (3) one adhesive can be a removable adhesive to enable application of a subpad/polishing layer pairing to a platen, and/or (4) one adhesive can be a permanent adhesive to promote strong bonding of the subpad to the back side of the polishing pad or layer.

To provide context, state of the art for subpad coupling to a polishing pad or layer involves use of a two-sided tape (such as a pressure sensitive adhesive, PSA, two-sided tape) to bond the subpad to the polishing pad. A second two-sided tape is laminated to the side of the subpad that will ultimately be coupled to a platen of a CMP apparatus. For example, fabrication of a polishing pad stack can involve laminating a PSA two-sided tape to both of the subpad faces.

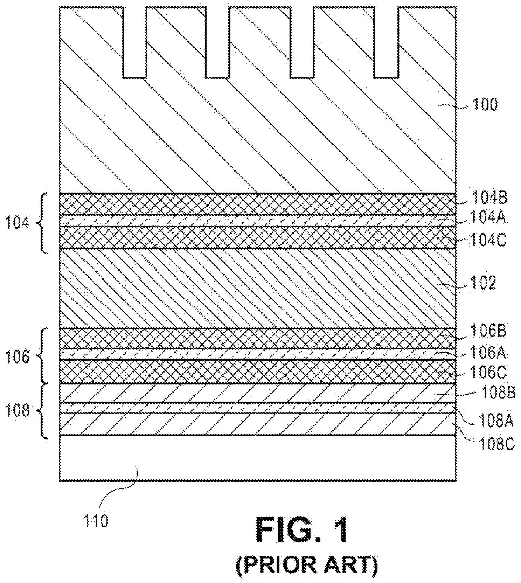

Figure 1 illustrates a cross-sectional view of a state of the art polishing pad and subpad pairing. Referring to Figure 1, a polishing pad 100 (top pad or polishing layer) is coupled to a subpad 102. The face of the subpad 102 proximate to the top pad 100 is coupled to the top pad 100 by a first PSA two-sided tape 104. The first PSA two-sided tape 104 may include a carrier film 104A (such as a polyethylene terephthalate, PET, film) which has a first permanent PSA layer 104B and a second permanent PSA layer 104C thereon. The face of the subpad 102 distal from the top pad 100 has a second PSA two-sided tape 106 thereon. The second PSA two-sided tape 106 may include a carrier film 106A (such as a PET film) which has a first permanent PSA layer 106B and a second permanent PSA layer 106C thereon. The second PSA two-sided tape 106 may be further coupled to a third PSA two-sided tape 108. The third PSA two-sided tape 108 may include a carrier film 108A (such as a PET film) which has a first permanent PSA layer 108B and a second removable PSA layer 108C thereon. The third PSA two-sided tape 108 may be suitable for removably coupling the top pad 100/subpad 102 polishing pad stack to a platen 110 of a CMP polishing apparatus, as is depicted in Figure 1. There may be disadvantages associated with the type of polishing pad stack depicted in Figure 1, as described below.

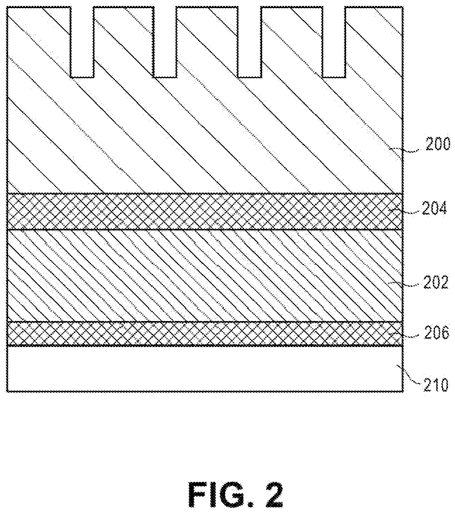

In contrast to the polishing pad stack of Figure 1, Figure 2 illustrates a cross-sectional view of a polishing pad and subpad pairing, in accordance with an embodiment of the present invention. Referring to Figure 2, a polishing pad stack for polishing a substrate includes a polishing pad 200 (top pad or polishing layer) coupled to a subpad 202, which may be a compressive subpad. The polishing pad 200 has a polishing surface distal from the subpad 202, and a back surface proximate to the subpad 202. A first (upper) surface of the subpad 202 has a first pressure sensitive adhesive layer 204 coated thereon. The upper surface of the subpad 202 is coupled directly to the back surface of the polishing pad 200 by the first pressure sensitive adhesive layer 204.

Referring again to Figure 2, in an embodiment, the polishing pad stack further includes a second pressure sensitive adhesive layer 206 coated on a second (lower) surface of the compressive subpad 202. In one such embodiment, the first pressure sensitive adhesive layer 204 is a permanent pressure sensitive adhesive layer for strong adhesion to the polishing pad 200. The second pressure sensitive adhesive layer 206 is a removable pressure sensitive adhesive layer and is for removably coupling the polishing pad stack to a platen 210 of a chemical mechanical polishing apparatus. Although depicted in Figure 2 as already coupled to a platen, in an embodiment, the polishing pad stack of Figure 2 may include a release liner on the second pressure sensitive adhesive layer 206. Such a release liner may be used for transport and storage of a polishing pad stack, and may be removed to expose the second pressure sensitive adhesive layer 206 prior to coupling the polishing pad stack to a platen.

Advantages of the polishing pad stack of Figure 2 over the polishing pad stack of Figure 1 may be realized from the non-interrupted subpad construction achieved with the polishing pad stack type of Figure 2. In particular, the number of interfaces is limited for adhesion failure. Additionally, there may be less processing of the adhesive layers of the polishing pad stack of Figure 2, as is described in greater detail below. In an embodiment, direct coating of an adhesive onto a compressive subpad surface aids in sealing foam pores in the case of a compressive foam subpad. Furthermore, the overall pad thickness may be reduced since there are no carrier films associated with the pressure sensitive adhesive layers, and the number of layers in the composite material is limited. In an embodiment, direct adhesive coating offers superior adhesive anchorage to low surface energy foam that would otherwise be difficult when laminating a PSA two-sided tape to the surface of the subpad. Finally, the number of manufacturing operations may be reduced from four to as low as one lamination operation (the lamination a coated subpad to a polishing pad), as is described in greater detail below. Such a reduction in lamination operations and the achieved simplicity of construction of the polishing pad stack can result in potential reductions in manufacturing cost of the polishing pad stack.

Referring again to Figure 2, a pressure sensitive adhesive layer, such as permanent pressure sensitive adhesive layer 204 or removable adhesive layer 206, requires only light to moderate pressure to adhere to a workpiece (such as light to moderate pressure to adhere a subpad 202 having a pressure sensitive adhesive layer coated thereon to a polishing pad 200). A pressure sensitive adhesive layer is not a glue layer which would otherwise require some level of curing. A pressure sensitive adhesive layer is also not a hot melt layer which otherwise requires heat for the adhesion to a workpiece. A pressure sensitive adhesive layer, as defined herein, also does not require the addition of water to activate the adhesion to a workpiece.

Referring again to Figure 2, in an embodiment, the permanent pressure sensitive adhesive layer 204 has a peel strength of greater than approximately 788 N/m (4.5 pounds per inch) at 25 degrees Celsius. The removable pressure sensitive adhesive layer 206 has a peel strength of less than approximately 700 N/m (4 pounds per inch) at 25 degrees Celsius. In a particular embodiment, the removable pressure sensitive adhesive layer 206 has a peel strength of less than approximately 438 N/m (2.5 pounds per inch) at 25 degrees Celsius. As used herein, peel strength is defined as strength at maximum adhesion of the pressure sensitive layer, where the test method use is defined in ASTM D3330. In an embodiment, the permanent pressure sensitive adhesive layer 204 or the removable pressure sensitive adhesive layer 206, or both, is a layer of material such as, but not limited to, an acrylic material, a rubber, ethylene vinyl acetate, a silicone material, or a block co-polymer. The layer often incudes a tackifying resin in the formulation. In an embodiment, the permanent pressure sensitive adhesive layer 204 or the removable pressure sensitive adhesive layer 206, or both, has a thickness of approximately 50.8 micrometer (2 mils).

As mentioned briefly above, in an embodiment, the compressive subpad 202 is a compressive foam subpad. In one such embodiment, the compressive foam subpad is post processed foam material (e.g., processed using a Corona treatment, as described in greater detail below) that provides improved thickness uniformity or improved surface energetics, or both. In an embodiment, the compressive foam subpad is composed of a material such as, but not limited to, an ethylene vinyl acetate closed cell foam material, a polyethylene closed cell foam material, or a polyurethane mostly closed cell foam material. In an embodiment, one or both of the surface of the compressive subpad (i.e., the surface that is coupled to a polishing pad or the surface for coupling to a platen) has a surface energy approximately in the range of 30-40 dyne/cm² (as measured prior to any post processing such as a Corona treatment). In an embodiment, the compressive subpad has a thickness approximately in the range of 254 micrometer to 1016 micrometer (10 mils to 40 mils).

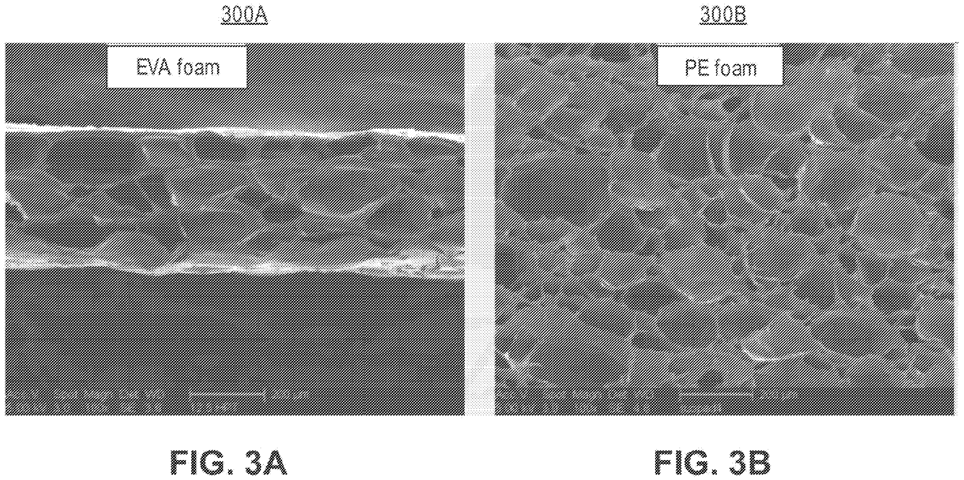

Figures 3A and 3B are cross-sectional scanning electron microscope (SEM) images of exemplary compressive foam subpads, in accordance with an embodiment of the present invention. Referring to SEM image 300A of Figure 3A, a closed cell ethyl vinyl acetate (EVA) foam subpad is shown magnified at 100X magnification. Referring to SEM image 300B of Figure 3B, a closed cell polyethylene (PE) foam subpad is shown magnified at 100X magnification.

Referring again to Figures 3A and 3B, in an embodiment, the subpad foam layer is an EVA foam or polyethylene foam having low surface energy, typically 30-35 dyne/cm². The surface energy is typically measured with an Accu Dyne pen that applies a simple solution using ASTM standard Test Method D 2578. The most common solution used includes ethyl cellosolve, formamide and a dye to make it easier to detect with the naked eye. The variation in concentration of the ethyl cellosolve % vs. the formamide % results in different dyne level solutions with each pen.

Referring again to Figure 2, the permanent pressure sensitive adhesive layer 204 is coated on the surface of the subpad 202 proximate to the polishing pad 200. The removable pressure sensitive adhesive layer 206 is coated on the surface of the subpad 202 distal to the polishing pad 200. Use of the term "coated" is used to distinguish embodiments of the present invention from situations where a PSA such as a PSA two-sided tape is laminated on the surface of a subpad for ultimate coupling of the subpad to a polishing pad or to a platen (depending on the side of the subpad having the PSA laminated thereon). The term "coated" is also used to distinguish embodiments of the present invention from situations where a PSA such as a PSA two-sided tape is first laminated on the back surface of a polishing pad and subsequently used to adhere the polishing pad to the subpad through another lamination process. By contrast, in accordance with embodiments described herein, an adhesive layer is coated on a surface of a subpad as a "wet" layer by a process such as, but not limited to, a dipping process, a rolling process, or a spreading process. The coated layer is then dried to remove any carrier solvents used to apply the adhesive material on the surface of the subpad. The dried layer coated on a subpad surface is the pressure sensitive adhesive layer (either permanent or removable, depending on which side of the subpad is referenced).

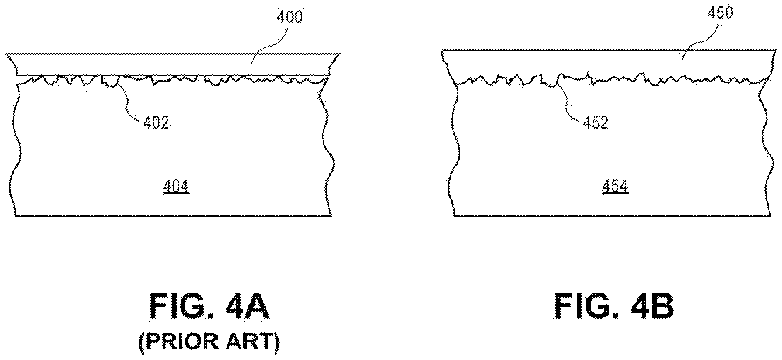

As an exemplary advantage of a coated adhesive layer as opposed to a laminated adhesive film on the surface of a subpad, embodiments of the present invention provide a pressure sensitive adhesive layer on the surface of a subpad where the surface area contact between the pressure sensitive adhesive layer and the surface of the subpad is greater than approximately 90%, and in some embodiments greater than approximately 95%. Figure 4A illustrates a cross-sectional view of a state of the art subpad having an adhesive film laminated thereon. Figure 4B illustrates a cross-sectional view of a subpad having a pressure sensitive adhesive layer coated thereon, in accordance with an embodiment of the present invention.

Referring to Figure 4A, a conventional laminated adhesive sheet 400 may not have substantial surface area contact between the laminated sheet 400 and a topographical surface 402 of a closed cell sub pad 404. As shown in Figure 4A, the laminated adhesive sheet 400 does not substantially fill surface voids/topography 402 of a surface of the subpad 404. It is to be appreciated that the same scenario may occur for the other (bottom) surface of the subpad 404.

By contrast, in accordance with an embodiment of the present invention, referring to Figure 4B, a coated pressure sensitive adhesion layer 450 substantially fills surface voids/topography 452 of a surface of a subpad 454. The result can be an ultimate increase in adhesion strength between the pressure sensitive adhesion layer 450 and the subpad 454. It is to be appreciated that the same scenario may occur for the other (bottom) surface of the subpad 454. In an exemplary embodiment, the surface 452 of the compressive subpad 454 has a surface roughness of at least 3 microns and has a total surface area. The coated pressure sensitive adhesive layer 450 is in direct contact with at least 90% of the total surface area of the surface 452 of the compressive subpad 454. In some embodiment, the coated pressure sensitive adhesive layer 450 is in direct contact with greater than approximately 95% of the total surface area of the surface 452 of the compressive subpad 454.

Referring again to Figure 2, in an embodiment, the polishing pad 200 coupled to the subpad 202 is a homogeneous or single layer polishing pad, as is depicted in Figure 2. In one such embodiment, the polishing pad 200 is composed of a thermoset polyurethane material, as described in greater detail below. In another embodiment, however, the polishing pad 200 is a composite polishing pad. In one such embodiment, the polishing pad 200 includes a polishing layer and a foundation layer that together define the polishing pad 200.

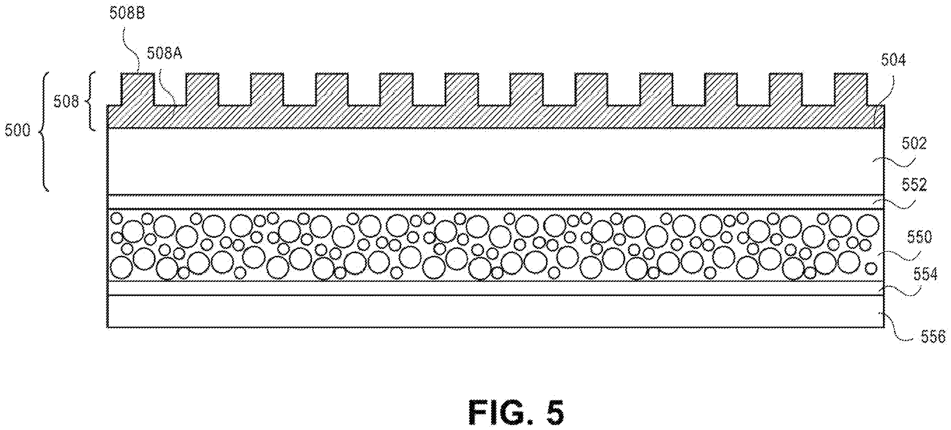

As an example of the latter scenario, Figure 5 illustrates a cross-sectional view of a polishing pad and subpad pairing where the polishing pad includes a polishing layer and a foundation layer, in accordance with an embodiment of the present invention. Referring to Figure 5, a polishing pad stack includes a polishing pad 500. The polishing pad includes a polishing layer 508 coupled to a foundation layer 502. As such, the back surface of the polishing pad 500 is a surface of the foundation layer 502. The front surface 504 of the foundation layer 502 is bonded to a surface polishing layer 508. In an embodiment, the polishing surface layer 508 includes a continuous layer portion 508A with a plurality of polishing features 508B protruding there from, as depicted in Figure 5. It is the continuous layer portion 508A that is bonded with the foundation layer 502.

In an embodiment, the foundation layer 502 is composed of a polycarbonate material, and the polishing surface layer 508 is a polyurethane material. In a specific such embodiment, the polishing surface layer 508 is covalently bonded to the foundation layer 502. The term "covalently bonded" refers to arrangements where atoms from a first material (e.g., the material of a polishing surface layer) are cross-linked or share electrons with atoms from a second material (e.g., the material of a foundation layer) to effect actual chemical bonding. Covalent bonding is distinguished from mechanical bonding, such as bonding through screws, nails, glues, or other adhesives. In another specific embodiment, the polishing surface layer 508 is not covalently bonded, but is rather only electrostatically bonded (yet still directly bonded), to the foundation layer 502. Such electrostatic bonding may involve van der Waals type interactions between the foundation layer 502 and the polishing surface layer 508.

Referring again to Figure 5, the polishing pad stack includes subpad 550, which may be a compressive closed cell foam subpad. A first (upper) surface of the subpad 550 has a first pressure sensitive adhesive layer 552 coated thereon. The upper surface of the subpad 550 is coupled directly to the back surface of the foundation layer 502 of the polishing pad 500 by the first pressure sensitive adhesive layer 552. In an embodiment, a second pressure sensitive adhesive layer 554 is coated on a second (lower) surface of the compressive subpad 550. In one such embodiment, the first pressure sensitive adhesive layer 552 is a permanent pressure sensitive adhesive layer for strong adhesion to the polishing pad 500. The second pressure sensitive adhesive layer 554 is a removable pressure sensitive adhesive layer and is for removably coupling the polishing pad stack to a platen 556 of a chemical mechanical polishing apparatus. Although depicted in Figure 5 as already coupled to a platen, in an embodiment, the polishing pad stack of Figure 5 may include a release liner on the second pressure sensitive adhesive layer 554. Such a release liner may be used for transport and storage of a polishing pad stack, and may be removed to expose the second pressure sensitive adhesive layer 554 prior to coupling the polishing pad stack to a platen.

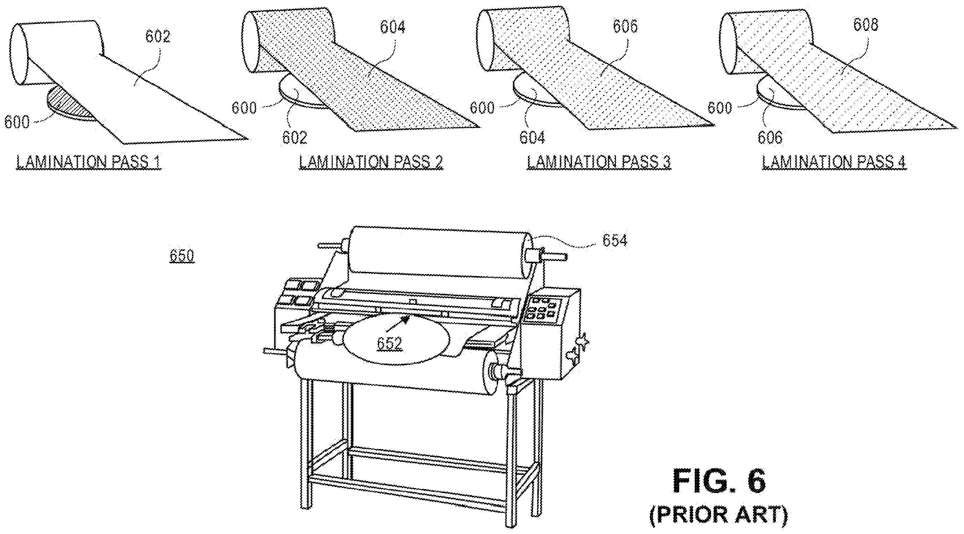

As mentioned briefly above, polishing pad stacks including subpads such as those described herein may be fabricated using a reduced number of lamination processes than are otherwise used for state of the art pad stack fabrication. As a comparative example, Figure 6 illustrates a state of the art four step lamination pass pad/subpad fabrication process. Referring to Figure 6, a first lamination pass (Lamination Pass 1) involves lamination of a permanent PSA two-sided tape 602 on the back side of a polishing pad (top pad) 600. Excess of the permanent PSA two-sided tape is then trimmed off. A second lamination pass (Lamination Pass 2) involves lamination of a subpad foam material 604 onto the permanent PSA two-sided tape 602 on the back up the polishing pad 600. Excess of the foam material is then trimmed off. A third lamination pass (Lamination Pass 3) involves lamination of a second permanent PSA two-sided tape 606 onto the subpad foam material 604. Excess of the second permanent PSA two-sided tape is then trimmed off. A fourth lamination pass (Lamination Pass 4) involves lamination of a removable PSA two-sided tape 608 onto the second permanent PSA two-sided tape 606. Excess of the removable PSA two-sided tape is then trimmed off. A laminator 650 may be used where the polishing pad 652 is laminated with a roll 654 of the permanent PSA two-sided tape 602, the subpad foam material 604, the second permanent PSA two-sided tape 606 or the removable PSA two-sided tape 608, depending on which lamination pass is being performed. The resulting pad stack may be one such as described in association with Figure 1.

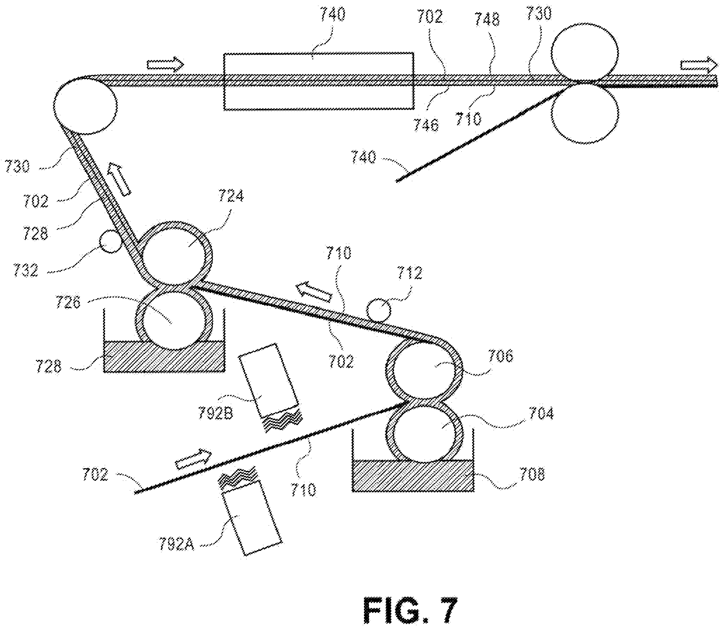

In contrast to the above described multi-lamination process, Figure 7 illustrates a subpad fabrication process involving coating of pressure sensitive adhesive layers onto the subpad material, in accordance with an embodiment of the present invention.

Referring to Figure 7, a subpad foam material 702 is used as a carrier film for a coating process. The subpad foam material 702 is fed into application rollers 704 and 706 which apply a first pressure sensitive adhesive material 708 onto a first side 710 of the subpad foam material 702. A spreader bar or Meyer bar 712 is used to remove excess of and to evenly distribute the first pressure sensitive adhesive material 708 on the first side 710 of the subpad foam material 702.

Referring again to Figure 7, the subpad foam material 702 is then fed into application rollers 724 and 726 which apply a second pressure sensitive adhesive material 728 onto a second side 730 of the subpad foam material 702. A spreader bar or Meyer bar 732 is used to remove excess of and to evenly distribute the second pressure sensitive adhesive material 728 on the second side 730 of the subpad foam material 702.

Referring again to Figure 7, the doubly coated subpad foam material 702 is then directed to a dryer 740. The drying provides a foam material 702 having a first surface 710 with a first pressure sensitive adhesive layer 746 coated thereon, and having a second surface 730 with a second pressure sensitive adhesive layer 748 coated thereon. Once transported through the dryer 740, further processing of the foam material 702 having the first 746 and second 748 pressure sensitive adhesive layers thereon may be performed, as described in greater detail below.

Referring generally to Figure 7, in an embodiment, a method of fabricating a polishing pad stack for polishing a substrate involves coating a first pressure sensitive adhesive layer 708 on a first surface 710 of a compressive subpad material 702. The method also involves coating a second pressure sensitive adhesive layer 728 on a second, opposite, surface 730 of the compressive subpad material 702. In an embodiment, the first pressure sensitive adhesive layer 708 is a permanent pressure sensitive adhesive layer, and the second pressure sensitive adhesive layer 728 is a removable pressure sensitive adhesive layer. In another embodiment, the first pressure sensitive adhesive layer 708 is a removable pressure sensitive adhesive layer, and the second pressure sensitive adhesive layer 728 is a permanent pressure sensitive adhesive layer. In either case, in an embodiment, for the removable pressure sensitive adhesive layer, a primer is applied to the associated side of the subpad material for increasing the adhesion of the removable pressure sensitive adhesive layer to the subpad material but retaining removability for the platen side of the removable pressure sensitive adhesive layer.

In an embodiment, coating of either the first or second pressure sensitive adhesive layer involves dispensing and then spreading a solvent-based adhesive formulation on a surface of the compressive subpad material. In one such embodiment, subsequent to dispensing and then spreading a first solvent-based adhesive formulation on a first surface of the compressive subpad material and dispensing and then spreading a second solvent-based adhesive formulation on a second surface of the compressive subpad material, the first and second solvent-based adhesive formulations are dried (e.g., through dryer 740) to remove substantially all solvent from the first and second solvent-based adhesive formulations. In an embodiment, a pressure sensitive adhesive layer is applied as a solvent-based adhesive formulation on a surface of the compressive subpad material at a temperature less than approximately 50 degrees Celsius. Subsequently, the solvent-based adhesive formulation is dried in an air dryer at a temperature less than approximately 50 degrees Celsius.

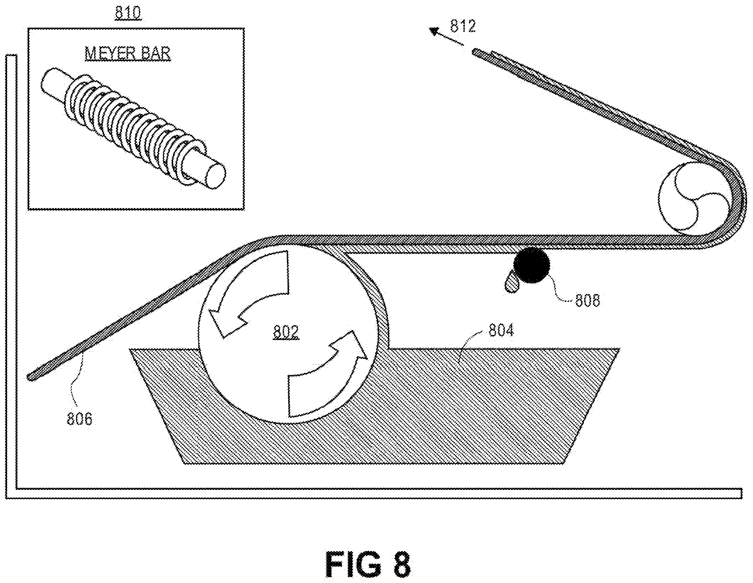

Thus, referring generally to Figure 7, providing PSA layers on a subpad material involves coating an adhesive/solvent solution onto the subpad material which acts a carrier film or a support layer in the fabrication process. The viscosity of the adhesive formulation determines the coating method. The adhesive formulation can be applied as an adhesive material carried in a solvent. An exemplary coating method is a Meyer Rod Coating approach. Figure 8 illustrates coating of a pressure sensitive adhesive layer onto a subpad material using a Meyer bar, in accordance with an embodiment of the present invention.

Referring to Figure 8, an applicator roll 802 delivers an adhesive formulation 804 to the surface of a subpad material 806 being coated. In an embodiment, the adhesive formulation 804 is applied at a temperature less than approximately 50 degrees Celsius and, preferably less than approximately 40 degrees Celsius, and most preferably at room temperature or approximately 20-25 degrees Celsius. In an embodiment, the temperature of the adhesive formulation 804 at the time of application is less than approximately 50 degrees Celsius and, preferably less than approximately 40 degrees Celsius, and most preferably at room temperature or approximately 20-25 degrees Celsius. The applicator roll 802 delivers an excess of material 804. The excess is removed by a Meyer rod or bar 808 (an expanded view of which is depicted in box 810 of Figure 8, which shows the rod wrapped with wire). The amount of adhesive removed depends on the wire wrapping. There may be multiple rods in series to produce smooth accurate coating thicknesses with tolerance at +/- 0.0254 mm (+/- .001 inch). The coated subpad material film is then directed 812 to an air dryer for solvent evaporation. In an embodiment, the subpad having the adhesive coated thereon enters the dryer approximately 2-4 minutes after the adhesive is coated on the subpad. In an embodiment, the subpad is dried in the air dryer for approximately 20 minutes.

Referring again to Figure 7, a release liner 790 is then applied to one of the coated adhesive layers at the end of the coating process. In one embodiment, the release liner 790 is added to the removable pressure sensitive adhesive layer after the removable pressure sensitive adhesive layer has been coated on the subpad material. In other embodiments, however, the removable pressure sensitive adhesive layer is coated on the subpad material by first applying the removable pressure sensitive adhesive material to the release liner and then delivering the removable pressure sensitive adhesive material to the subpad material. In either case, such a release liner may be removed prior to coupling the removable pressure sensitive adhesive layer to a platen.

In an embodiment, although not depicted, a second release liner is added to the permanent pressure sensitive adhesive layer. Such a second release liner may be included for transporting or storage of a coated subpad, but removed prior to adhering the coated subpad to a polishing pad via the permanent pressure sensitive adhesive layer of the coated subpad. In other embodiments, however, a roll of the subpad material is formed without a release liner being included on the side of the subpad material having the permanent pressure sensitive adhesive layer thereon. Whether or not the second release liner is included, a polishing pad may be adhered to the coated permanent pressure sensitive adhesive layer of the subpad material by a lamination process (thus leaving a single lamination process in place of the four described in association with Figure 6). The subpad material may then be cut around the shape of the polishing pad material.

As described herein, a release liner is a paper or plastic based carrier web material, which has a release agent on one or both sides of the release liner. The release agent provides a release effect against any type of a sticky material such as an adhesive. Release of the release liner involves separation of the release liner from the pressure sensitive adhesive layer.

With reference again to the process of Figure 7, in an embodiment, the foam material (such as EVA or PE foam material) of the subpad is post processed prior to adhesive coating to achieve a tight gage tolerance of +/- 1mil throughout the web. Typically, the material is buffed on one or both sides. Such foams can vary in thickness from 381 micrometer up to 1524 micormeter (15 mils up to 60 mils) and may be produced in a wide range of densities ranging from a few kg up to 27 kg (few pounds up to 60 pound) foam. Typical gage tolerance is +/ 10% of the total thickness, which can be as much as 152 micrometer or a total of 304 micrometer (+/- 6 mils or a total of 12 mils) throughout the web. It is to be appreciated that, as the semiconductor market technologies become more and more demanding to reduce line width, the consumable set used to manufacture these technologies must also meet tighter material property tolerances. Post processing of a foam and subsequent direct adhesive coating can, in an embodiment, reduce the thickness tolerance and provide improved adhesive anchorage. Such factors in turn affect the foam compressibility of the subpad material. Compressibility is defined as (thickness under a load minus initial thickness)/initial thickness. In some embodiment, the desired compressibility is low, e.g., typically less than 10%.

As described briefly in association with Figure 7, a corona 792A and 792B or like treatment may be applied to one or both sides of a subpad material prior to adhesive layer coating. It is to be appreciated that surface energy properties are an important consideration with industrial coatings. The surface energy dictates if an applied coating will be accepted by the surface; this is known as wetting. The definition of wetting is the ability of a liquid to maintain contact with a solid surface, resulting from intermolecular interactions when the two are brought together. The degree of wetting (wettability) is determined by a force balance between adhesive and cohesive forces. For adhesive coatings, the surface tension of the adhesive must be lower than the surface energy of the surface to which they are applied. In the case of a material such as an EVA foam, the surface energy of the substrate must be raised to ensure sufficient wet out of the applied liquid (pressure sensitive adhesive coating). There are number of methods for such surface treatment such as, but not limited to corona discharge, flame treatment, or plasma treatment. Such treatments may be implemented to increase the surface energy of an EVA or PE foam from 30 dyne/cm up to, e.g., 40-42 dynes/cm. In one such embodiment, a corona discharge treatment is applied to a compressive foam subpad material just prior to the adhesive coating process, as is shown in Figure 7.

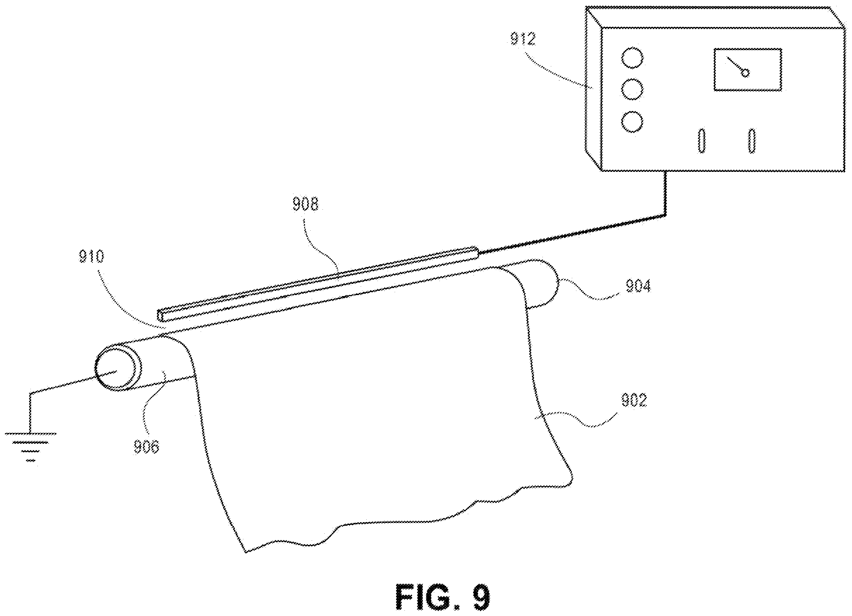

Figure 9 illustrates an apparatus for performing a Corona discharge treatment of a compressive foam subpad surface prior to coating an adhesive layer thereon, in accordance with an embodiment of the present invention. Referring to Figure 9, a subpad material layer 902 (e.g., compressive foam material layer) is rolled on a tamper roll 904 having a dielectric 906 thereon. The arrangement provides an electrode 908 above the subpad material layer 902 with an air gap 910 between the electrode 908 and the subpad material layer 902. A corona generator power supply 912 is coupled to the electrode 908. The corona treatment is a surface modification technique that uses a low temperature corona discharge plasma to impart changes in the properties of a surface of the subpad material layer 902.

In an embodiment, referring again to Figures 2 and 5, the polishing pad 200 or the polishing surface layer 508 is a homogeneous polishing pad or polishing surface layer. In one such embodiment, the homogeneous polishing pad or polishing surface layer is composed of a thermoset polyurethane material. For example, in a specific embodiment, the homogeneous polishing pad or polishing surface layer is composed of a thermoset, closed cell polyurethane material. In an embodiment, the term "homogeneous" is used to indicate that the composition of a thermoset, closed cell polyurethane material is consistent throughout the entire composition of the body. For example, in an embodiment, the term "homogeneous" excludes polishing pad bodies composed of, e.g., impregnated felt or a composition (composite) of multiple layers of differing material. In an embodiment, the term "thermoset" is used to indicate a polymer material that irreversibly cures, e.g., the precursor to the material changes irreversibly into an infusible, insoluble polymer network by curing. For example, in an embodiment, the term "thermoset" excludes polishing pads composed of, e.g., "thermoplast" materials or "thermoplastics" - those materials composed of a polymer that turns to a liquid when heated and returns to a very glassy state when cooled sufficiently. It is noted that polishing pads made from thermoset materials are typically fabricated from lower molecular weight precursors reacting to form a polymer in a chemical reaction, while pads made from thermoplastic materials are typically fabricated by heating a pre-existing polymer to cause a phase change so that a polishing pad is formed in a physical process. Polyurethane thermoset polymers may be selected for fabricating polishing pads described herein based on their stable thermal and mechanical properties, resistance to the chemical environment, and tendency for wear resistance.

The materials of polishing pad 200 or polishing surface layer 508 may be molded. The term "molded" may be used to indicate that the polishing surface layer is formed in a formation mold. In an embodiment, the molded polishing pad 200 or polishing surface layer 508, upon conditioning and/or polishing, has a polishing surface roughness approximately in the range of 1 - 5 microns root mean square. In one embodiment, the molded polishing pad 200 or polishing surface layer 508, upon conditioning and/or polishing, has a polishing surface roughness of approximately 2.35 microns root mean square. In an embodiment, the molded polishing pad 200 or polishing surface layer 508 has a storage modulus at 25 degrees Celsius approximately in the range of 30 - 500 megaPascals (MPa). In another embodiment, the molded polishing pad 200 or polishing surface layer 508 has a storage modulus at 25 degrees Celsius approximately less than 30 megaPascals (MPa).

The materials of polishing pad 200 or polishing surface layer 508 may include pore-forming features. In an embodiment, the polishing surface layer 108 or 208 has a pore density of closed cell pores approximately in the range of 6% - 50% total void volume. In one embodiment, the plurality of closed cell pores is a plurality of porogens. For example, the term "porogen" may be used to indicate micro- or nano-scale spherical or somewhat spherical particles with "hollow" centers. The hollow centers are not filled with solid material, but may rather include a gaseous or liquid core. In one embodiment, the plurality of closed cell pores is composed of pre-expanded and gas-filled EXPANCEL^{™} distributed throughout (e.g., as an additional component in) a polishing surface layer of a polishing pad. In a specific embodiment, the EXPANCEL^{™} is filled with pentane. In an embodiment, each of the plurality of closed cell pores has a diameter approximately in the range of 10 - 100 microns. In an embodiment, the plurality of closed cell pores includes pores that are discrete from one another. This is in contrast to open cell pores which may be connected to one another through tunnels, such as the case for the pores in a common sponge. In one embodiment, each of the closed cell pores includes a physical shell, such as a shell of a porogen, as described above. In another embodiment, however, each of the closed cell pores does not include a physical shell. In an embodiment, the plurality of closed cell pores is distributed essentially evenly throughout a thermoset polyurethane material of a homogeneous polishing pad or polishing surface layer.

In an embodiment, polishing pad 200 or polishing surface layer 508 is opaque. In one embodiment, the term "opaque" is used to indicate a material that allows approximately 10% or less visible light to pass. In one embodiment, the polishing pad 200 or polishing surface layer 508 is opaque in most part, or due entirely to, the inclusion of an opacifying particle filler, such as a lubricant, throughout (e.g., as an additional component in) the polishing pad 200 or polishing surface layer 508. In a specific embodiment, the opacifying particle filler is a material such as, but not limited to boron nitride, cerium fluoride, graphite, graphite fluoride, molybdenum sulfide, niobium sulfide, talc, tantalum sulfide, tungsten disulfide, or Teflon^{®}.

In another aspect, the polishing pad 200 or polishing surface layer 508 may have a pattern suitable for polishing during a CMP operation. In a first general example, some embodiments of the present invention include a plurality of protrusions having a pattern of linear features. In a second general example, some embodiments of the present invention include a plurality of protrusions having a pattern of discrete curved features. In a specific such example, discrete arc-shaped protrusions are included. Other specific such embodiments include, but are not limited to, a plurality of partial circumferential protrusions disposed on a substantially circular polishing pad. In a third general example, some embodiments of the present invention include a plurality of protrusions having a pattern of discrete tiles. In a specific such embodiment, discrete hexagonal tile protrusions are included. Other specific such embodiments include, but are not limited to, pluralities of circular tiles, oval tiles, square tiles, rectangular tiles, or a combination thereof.

Although the above three general examples are defined in terms of protrusions (e.g., the highest points of a patterned polishing surface layer), the polishing surface layers may also or alternatively be defined in terms of grooves (e.g., the lowest points of a patterned polishing surface layer). Individual grooves may be from about 102 micrometer to about 2540 micrometer (4 to about 100 mils) deep at any given point on each groove. In some embodiments, the grooves are about 254 to about 1270 micrometer (10 to about 50 mils) deep at any given point on each groove. The grooves may be of uniform depth, variable depth, or any combinations thereof. In some embodiments, the grooves are all of uniform depth. For example, the grooves of a groove pattern may all have the same depth. In some embodiments, some of the grooves of a groove pattern may have a certain uniform depth while other grooves of the same pattern may have a different uniform depth. For example, groove depth may increase with increasing distance from the center of the polishing pad. In some embodiments, however, groove depth decreases with increasing distance from the center of the polishing pad. In some embodiments, grooves of uniform depth alternate with grooves of variable depth.

Individual grooves may be from about 50.8 to about 2540 micrometer (2 to about 100 mils) wide at any given point on each groove. In some embodiments, the grooves are about 381 to about 1270 micrometer (15 to about 50 mils) wide at any given point on each groove. The grooves may be of uniform width, variable width, or any combinations thereof. In some embodiments, the grooves of a groove pattern are all of uniform width. In some embodiments, however, some of the grooves of a groove pattern have a certain uniform width, while other grooves of the same pattern have a different uniform width. In some embodiments, groove width increases with increasing distance from the center of the polishing pad. In some embodiments, groove width decreases with increasing distance from the center of the polishing pad. In some embodiments, grooves of uniform width alternate with grooves of variable width.

In accordance with the previously described depth and width dimensions, individual grooves may be of uniform volume, variable volume, or any combinations thereof. In some embodiments, the grooves are all of uniform volume. In some embodiments, however, groove volume increases with increasing distance from the center of the polishing pad. In some other embodiments, groove volume decreases with increasing distance from the center of the polishing pad. In some embodiments, grooves of uniform volume alternate with grooves of variable volume.

Grooves of the groove patterns described herein may have a pitch from about 762 to about 25400 micrometer (30 to about 1000 mils) In some embodiments, the grooves have a pitch of about 3175 micrometer (125 mils). For a circular polishing pad, groove pitch is measured along the radius of the circular polishing pad. The grooves may be of uniform pitch, variable pitch, or in any combinations thereof. In some embodiments, the grooves are all of uniform pitch. In some embodiments, however, groove pitch increases with increasing distance from the center of the polishing pad. In some other embodiments, groove pitch decreases with increasing distance from the center of the polishing pad. In some embodiments, the pitch of the grooves in one sector varies with increasing distance from the center of the polishing pad while the pitch of the grooves in an adjacent sector remains uniform. In some embodiments, the pitch of the grooves in one sector increases with increasing distance from the center of the polishing pad while the pitch of the grooves in an adjacent sector increases at a different rate. In some embodiments, the pitch of the grooves in one sector increases with increasing distance from the center of the polishing pad while the pitch of the grooves in an adjacent sector decreases with increasing distance from the center of the polishing pad. In some embodiments, grooves of uniform pitch alternate with grooves of variable pitch. In some embodiments, sectors of grooves of uniform pitch alternate with sectors of grooves of variable pitch.

In an embodiment, polishing pad stacks described herein, such as the polishing pad stacks of Figures 2 and 5, are suitable for polishing substrates. The substrate may be one used in the semiconductor manufacturing industry, such as a silicon substrate having device or other layers disposed thereon. However, the substrate may be one such as, but not limited to, a substrates for MEMS devices, reticles, or solar modules. Thus, reference to "a polishing pad for polishing a substrate," as used herein, is intended to encompass these and related possibilities. In an embodiment, a polishing pad stack has a diameter approximately in the range of 20 inches to 30.3 inches, e.g., approximately in the range of 50 - 77 centimeters, and possibly approximately in the range of 10 inches to 42 inches, e.g., approximately in the range of 25 - 107 centimeters.

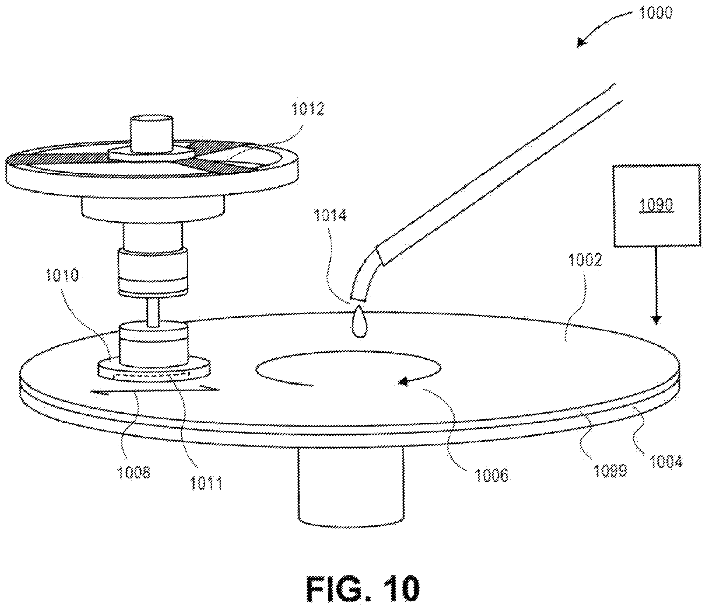

Subpads described herein may be included with a polishing pad, as described above. Such a combined polishing pad/subpad polishing pad stack may be suitable for use with a variety of chemical mechanical polishing apparatuses. As an example, Figure 10 illustrates an isometric side-on view of a polishing apparatus compatible with a polishing pad/subpad polishing pad stack, in accordance with an embodiment of the present invention.

Referring to Figure 10, a polishing apparatus 1000 includes a platen 1004. The top surface 1002 of platen 1004 may be used to support a polishing pad/subpad polishing pad stack 1099. Platen 1004 may be configured to provide spindle rotation 1006. A sample carrier 1010 is used to hold, e.g., a semiconductor wafer 1011 in place during polishing of the semiconductor wafer with the polishing pad/subpad polishing pad stack 1099 and to provide slider oscillation 1008. Sample carrier 1010 is further supported by a suspension mechanism 1012. A slurry feed 1014 is included for providing slurry to a surface of the polishing pad/subpad polishing pad stack 1099 prior to and during polishing of the semiconductor wafer. A conditioning unit 1090 may also be included and, in one embodiment, includes a diamond tip for conditioning the polishing pad of the polishing pad/subpad polishing pad stack 1099 combination. In an embodiment, a relatively weaker adhesive coated adhesive layer on the subpad is used to mount the polishing pad/subpad polishing pad stack 1099 on the platen 1004. In an embodiment, a relatively stronger adhesive coated adhesive layer secures the subpad to the polishing pad.

Thus, coated compressive subpads for polishing pad stacks and methods of fabricating coated compressive subpads for polishing pad stacks have been disclosed.

## Claims

1. A polishing pad stack for polishing a substrate, the polishing pad stack comprising:
a polishing pad (200, 500) having a polishing surface and a back surface; and
a compressive subpad (202, 550) with a first surface having a first pressure sensitive adhesive layer (204, 552) coated thereon, the first surface of the compressive subpad (202, 550) coupled directly to the back surface of the polishing pad (200, 500) by the first pressure sensitive adhesive layer (204, 552),
**characterized in that** the first surface of the compressive subpad (202, 550) has a surface energy approximately in the range of 0.3-0.4 Pa (30-40 dyne/cm²) and wherein the first surface of the compressive subpad (202, 550) has a surface roughness of at least 3 microns and has a total surface area, and the first pressure sensitive adhesive layer (204, 552) is in direct contact with at least 90% of the total surface area of the first surface of the compressive subpad.

2. The polishing pad stack of claim 1, further comprising:
a second pressure sensitive adhesive layer (206, 554) coated on a second surface of the compressive subpad, the second surface of the compressive subpad (202, 550) opposite the first surface.

3. The polishing pad stack of claim 2, wherein the first pressure sensitive adhesive layer (204, 552) is a permanent pressure sensitive adhesive layer, and wherein the second pressure sensitive adhesive layer (206, 554) is a removable pressure sensitive adhesive layer.

4. The polishing pad stack of claim 3, wherein the removable pressure sensitive adhesive layer is for coupling the polishing pad stack to a platen (210, 556) of a chemical mechanical polishing apparatus, further comprising:
a release liner (790) disposed on the removable pressure sensitive adhesive layer.

5. The polishing pad stack of claim 3, wherein the first pressure sensitive adhesive layer (204, 552) has a peel strength of greater than approximately 788.07 N/m (4.5 pounds per inch) at 25 degrees Celsius, and wherein the second pressure sensitive adhesive layer (206, 554) has a peel strength of less than approximately 700.50 N/m (4 pounds per inch) at 25 degrees Celsius, wherein optionally the second pressure sensitive adhesive layer (206, 554) has a peel strength of less than approximately 437.81 N/m (2.5 pounds per inch) at 25 degrees Celsius.

6. The polishing pad stack of claim 1, wherein the compressive subpad (202, 550) is a compressive foam subpad, wherein optionally the compressive foam subpad comprises a material selected from the group consisting of an ethylene vinyl acetate closed cell foam material, a polyethylene closed cell foam material, and a polyurethane mostly closed cell foam material.

7. The polishing pad stack of claim 1, wherein one of the following applies,
a) the compressive subpad (202, 550) has a thickness approximately in the range of 0.254 mm (10 mils) to 1.016 mm (40 mils);
b) the first pressure sensitive adhesive layer (204, 552) comprises a material selected from the group consisting of an acrylic material, a rubber, ethylene vinyl acetate, a silicone material, and a block co-polymer; and
c) the polishing pad (200, 500) comprises a thermoset polyurethane material.

8. The polishing pad stack of claim 2, wherein the polishing pad (200, 500) comprises a polishing layer (502) coupled to a foundation layer (502), and wherein the back surface of the polishing pad (200, 500) is a surface of the foundation layer (502).

9. A method of fabricating a polishing pad stack for polishing a substrate, the method comprising:
coating a first pressure sensitive adhesive layer (708) on a first surface (710) of a compressive subpad material (702);
coating a second pressure sensitive adhesive layer (728) on a second, opposite, surface (730) of the compressive subpad material (702); and
adhering the first surface (710) of the compressive subpad material (702) directly to a back surface of a polishing pad by the first pressure sensitive adhesive layer (708);
**characterized in that** the first surface (710) of the compressive subpad material (702) has a surface energy approximately in the range of 0.3-0.4 Pa (30-40 dyne/cm²) and wherein the first surface (710) of the compressive subpad material (702) has a surface roughness of at least 3 microns and has a total surface area, and the first pressure sensitive adhesive layer (708) is in direct contact with at least 90% of the total surface area of the first surface (710) of the compressive subpad material (702).

10. The method of claim 9, coating the first pressure sensitive adhesive layer (708) comprises coating a permanent pressure sensitive adhesive layer, and wherein coating the second pressure sensitive adhesive layer (728) comprises coating a removable pressure sensitive adhesive layer.

11. The method of claim 9, wherein coating the first pressure sensitive adhesive layer (708) comprises dispensing and then spreading a first solvent-based adhesive formulation on the first surface (710) of the compressive subpad material (702), and wherein coating the second pressure sensitive adhesive layer (728) comprises dispensing and then spreading a second solvent-based adhesive formulation on the second surface (730) of the compressive subpad material (702).

12. The method of claim 11, wherein one of the following applies,
a) dispensing and then spreading the first solvent-based adhesive formulation on the first surface (710) of the compressive subpad material (702) is performed prior to dispensing and then spreading the second solvent-based adhesive formulation on the second surface (730) of the compressive subpad material (702);
b) dispensing and then spreading the first solvent-based adhesive formulation on the first surface (710) of the compressive subpad material (702) is performed subsequent to dispensing and then spreading the second solvent-based adhesive formulation on the second surface (730) of the compressive subpad material (702); and
c) the method further comprising:
subsequent to dispensing and then spreading the first solvent-based adhesive formulation on the first surface (710) of the compressive subpad material (702) and dispensing and then spreading the second solvent-based adhesive formulation on the second surface (730) of the compressive subpad material (702), drying the first and second solvent-based adhesive formulations to remove substantially all solvent from the first and second solvent-based adhesive formulations.

13. The method of claim 9, wherein one of the following applies,
a) the compressive subpad is a compressive foam subpad, the method further comprising:
prior to coating the first and second pressure sensitive adhesive layers (728), treating at least one of the first or second surfaces (730) of the compressive foam subpad material with a process selected from the group consisting of a corona discharge treatment, a plasma treatment, and a flame treatment;
b) coating the first pressure sensitive adhesive layer (708) comprises applying a first solvent-based adhesive formulation on the first surface (710) of the compressive subpad material (702) at a temperature less than approximately 50 degrees Celsius and, subsequently, drying the first solvent-based adhesive formulation in an air dryer (740) at a temperature less than approximately 50 degrees Celsius;
c) the method further comprising:
applying a release liner (790) to the second pressure sensitive adhesive layer (728), wherein optionally the compressive subpad material (702) has a thickness approximately in the range of 0.254 mm (10 mils) to 1.016 mm (40 mils);
d) coating the second pressure sensitive adhesive layer (728) on the second, opposite, surface of the compressive subpad material (702) comprises applying the second pressure sensitive adhesive layer (728) to a release liner (790) and then applying the second pressure sensitive adhesive layer (728) to the second, opposite, surface of the compressive subpad by the release liner (790); and
e) adhering the first surface (710) of the compressive subpad material (702) directly to the back surface of the polishing pad comprises adhering the first surface (710) of the compressive subpad material (702) directly to the back surface of a thermoset polyurethane polishing pad.

14. A subpad for a polishing pad stack, the subpad comprising:
a compressive subpad material (702) having a first surface (710) and a second, opposite, surface;
a first pressure sensitive adhesive layer (708) coated on the first surface (710) of the compressive subpad material (702), and a first release liner (790) disposed on the first pressure sensitive adhesive layer (708); and
a second pressure sensitive adhesive layer (728) coated on the second surface (730) of the compressive subpad material (702),
**characterized in that** the first surface (710) of the compressive subpad material (702) has a surface energy approximately in the range of 0.3-0.4 Pa (30-40 dyne/cm²) and wherein the first surface (710) of the compressive subpad material (702) has a surface roughness of at least 3 microns and has a total surface area, and the first pressure sensitive adhesive layer (708) is in direct contact with at least 90% of the total surface area of the first surface (710) of the compressive subpad material (702).

15. The subpad of claim 14, wherein one of the following applies,
a) the subpad further comprising:
a second release liner disposed (790) on the second pressure sensitive adhesive layer (728);
b) the first pressure sensitive adhesive layer (708) is a removable pressure sensitive adhesive layer, and wherein the second pressure sensitive adhesive layer (728) is a permanent pressure sensitive adhesive layer, wherein optionally the permanent pressure sensitive adhesive layer is for coupling to a back surface of a polishing pad, and wherein the removable pressure sensitive adhesive layer is for coupling the subpad to a platen of a chemical mechanical polishing apparatus;
c) the second pressure sensitive adhesive layer (728) has a peel strength of greater than approximately 788.07 N/m (4.5 pounds per inch) at 25 degrees Celsius, and wherein the first pressure sensitive adhesive layer (708) has a peel strength of less than approximately 700.50N/m (4 pounds per inch) at 25 degrees Celsius;
d) the compressive subpad material (702) is a compressive foam subpad material comprising a material selected from the group consisting of an ethylene vinyl acetate closed cell foam material, a polyethylene closed cell foam material, and a polyurethane mostly closed cell foam material;
e) the compressive subpad material (702) is a compressive foam subpad material, and wherein the second surface (730) of the compressive foam subpad material has a surface energy approximately in the range of 0.3-0.4 Pa (30-40 dyne/cm²);
f) the second pressure sensitive adhesive layer (728) comprises a first material selected from the group consisting of an acrylic material, a rubber, ethylene vinyl acetate, a silicone material, and a block co-polymer, and wherein the first pressure sensitive adhesive layer (708) comprises a second material selected from the group consisting of an acrylic material, a rubber, ethylene vinyl acetate, a silicone material, and a block co-polymer; and
g) the second surface (730) of the compressive subpad material (702) has a surface roughness of at least 3 microns and has a total surface area, and the second pressure sensitive adhesive layer (728) is in direct contact with at least 90% of the total surface area of the second surface (730) of the compressive subpad material (702).

## Patentansprüche

1. Polierkissenstapel zum Polieren eines Substrats, der Polierkissenstapel Folgendes umfassend:
ein Polierkissen (200, 500) mit einer Polierfläche und einer Rückfläche; und
ein Druckunterkissen (202, 550) mit einer ersten Oberfläche, die eine erste druckempfindliche Klebeschicht (204, 552) aufweist, die darauf beschichtet ist, wobei die erste Oberfläche des Druckunterkissens (202, 550) durch die erste druckempfindliche Klebeschicht (204, 552) direkt mit der Rückfläche des Polierkissens (200, 500) gekoppelt ist,
**dadurch gekennzeichnet, dass** die erste Oberfläche des Druckunterkissens (202, 550) eine Oberflächenenergie ungefähr in dem Bereich von 0,3 bis 0,4 Pa (30 bis 40 dyn/cm²) aufweist, und wobei die erste Oberfläche des Druckunterkissens (202, 550) eine Oberflächenrauhigkeit von mindestens 3 Mikron aufweist und eine Gesamtoberfläche aufweist und die erste druckempfindliche Klebeschicht (204, 552) in direktem Kontakt mit mindestens 90 % der Gesamtoberfläche der ersten Oberfläche des Druckunterkissens steht.

2. Polierkissenstapel nach Anspruch 1, weiterhin Folgendes umfassend:
eine zweite druckempfindliche Klebeschicht (206, 554), die auf einer zweiten Oberfläche des Druckunterkissens beschichtet ist, wobei die zweite Oberfläche des Druckunterkissens (202, 550) der ersten Oberfläche entgegengesetzt ist.

3. Polierkissenstapel nach Anspruch 2, wobei die erste druckempfindliche Klebeschicht (204, 552) eine permanente druckempfindliche Klebeschicht ist und wobei die zweite druckempfindliche Klebeschicht (206, 554) eine entfernbare druckempfindliche Klebeschicht ist.

4. Polierkissenstapel nach Anspruch 3, wobei die entfernbare druckempfindliche Klebeschicht zum Koppeln des Polierkissenstapels mit einer Platte (210, 556) einer chemisch-mechanischen Poliervorrichtung dient, weiterhin Folgendes umfassend:
eine Trennfolie (790), die auf der entfernbaren druckempfindlichen Klebeschicht angeordnet ist.

5. Polierkissenstapel nach Anspruch 3, wobei die erste druckempfindliche Klebeschicht (204, 552) eine Ablösefestigkeit von mehr als ungefähr 788,07 N/m (4,5 Pfund pro Zoll) bei 25 Grad Celsius aufweist und wobei die zweite druckempfindliche Klebeschicht (206, 554) eine Ablösefestigkeit von weniger als ungefähr 700,50 N/m (4 Pfund pro Zoll) bei 25 Grad Celsius aufweist, wobei gegebenenfalls die zweite druckempfindliche Klebeschicht (206, 554) eine Ablösefestigkeit von weniger als ungefähr 437,81 N/m (2,5 Pfund pro Zoll) bei 25 Grad Celsius aufweist.

6. Polierkissenstapel nach Anspruch 1, wobei das Druckunterkissen (202, 550) ein Druckschaumunterkissen ist, wobei das Druckschaumunterkissen gegebenenfalls ein Material umfasst, das aus der Gruppe ausgewählt ist, bestehend aus einem geschlossenzelligen Ethylenvinylacetat-Schaummaterial, einem geschlossenzelligen Polyethylen-Schaummaterial und einem überwiegend geschlossenzelligen Polyurethan-Schaummaterial.

7. Polierkissenstapel nach Anspruch 1, wobei eines des Folgenden zutrifft,
a) das Druckunterkissen (202, 550) weist eine Dicke ungefähr in dem Bereich von 0,254 mm (10 Mil) bis 1,016 mm (40 Mil) auf;
b) die erste druckempfindliche Klebeschicht (204, 552) umfasst ein Material, das aus der Gruppe ausgewählt ist, bestehend aus einem Acryl-Material, einem Gummi, Ethylenvinylacetat, einem Silikon-Material und einem Blockcopolymer; und
c) das Polierkissen (200, 500) umfasst ein duroplastisches Polyurethan-Material.

8. Polierkissenstapel nach Anspruch 2, wobei das Polierkissen (200, 500) eine Polierschicht (502) umfasst, die mit einer Grundschicht (502) gekoppelt ist, und wobei die Rückfläche des Polierkissens (200, 500) eine Oberfläche der Grundschicht (502) ist.

9. Verfahren zum Herstellen eines Polierkissenstapels zum Polieren eines Substrats, das Verfahren Folgendes umfassend:
Beschichten einer ersten druckempfindlichen Klebeschicht (708) auf einer ersten Oberfläche (710) eines Druckunterkissenmaterials (702);
Beschichten einer zweiten druckempfindlichen Klebeschicht (728) auf einer zweiten entgegengesetzten Oberfläche (730) des Druckunterkissenmaterials (702);
Kleben der ersten Oberfläche (710) des Druckunterkissenmaterials (702) direkt auf eine Rückfläche eines Polierkissens durch die erste druckempfindliche Klebeschicht (708);
**dadurch gekennzeichnet, dass** die erste Oberfläche (710) des Druckunterkissenmaterials (702) eine Oberflächenenergie ungefähr in dem Bereich von 0,3 bis 0,4 Pa (30 bis 40 dyn/cm²) aufweist, und wobei die erste Oberfläche (710) des Druckunterkissenmaterials (702) eine Oberflächenrauhigkeit von mindestens 3 Mikron aufweist und eine Gesamtoberfläche aufweist und die erste druckempfindliche Klebeschicht (708) in direktem Kontakt mit mindestens 90 % der Gesamtoberfläche der ersten Oberfläche (710) des Druckunterkissenmaterials (702) steht.

10. Verfahren nach Anspruch 9, wobei Beschichten der ersten druckempfindlichen Klebeschicht (708) Beschichten einer permanenten druckempfindlichen Klebeschicht umfasst und wobei Beschichten der zweiten druckempfindlichen Klebeschicht (728) Beschichten einer entfernbaren druckempfindlichen Klebeschicht umfasst.

11. Verfahren nach Anspruch 9, wobei Beschichten der ersten druckempfindlichen Klebeschicht (708) ein Abgeben und dann Verteilen einer ersten lösemittelbasierten Klebstoffzubereitung auf der ersten Oberfläche (710) des Druckunterkissenmaterials (702) umfasst und wobei Beschichten der zweiten druckempfindlichen Klebeschicht (728) ein Abgeben und dann Verteilen einer zweiten lösemittelbasierten Klebstoffzubereitung auf der zweiten Oberfläche (730) des Druckunterkissenmaterials (702) umfasst.

12. Verfahren nach Anspruch 11, wobei eines des Folgenden zutrifft,
a) Abgeben und dann Verteilen der ersten lösemittelbasierten Klebstoffzubereitung auf der ersten Oberfläche (710) des Druckunterkissenmaterials (702) wird vor Abgeben und dann Verteilen der zweiten lösemittelbasierten Klebstoffzubereitung auf der zweiten Oberfläche (730) des Druckunterkissenmaterials (702) durchgeführt;
b) Abgeben und dann Verteilen der ersten lösemittelbasierten Klebstoffzubereitung auf der ersten Oberfläche (710) des Druckunterkissenmaterials (702) wird nach Abgeben und dann Verteilen der zweiten lösemittelbasierten Klebstoffzubereitung auf der zweiten Oberfläche (730) des Druckunterkissenmaterials (702) durchgeführt; und
c) das Verfahren weiterhin Folgendes umfassend:
nach Abgeben und dann Verteilen der ersten lösemittelbasierten Klebstoffzubereitung auf der ersten Oberfläche (710) des Druckunterkissenmaterials (702) und Abgeben und dann Verteilen der zweiten lösemittelbasierten Klebstoffzubereitung auf der zweiten Oberfläche (730) des Druckunterkissenmaterials (702), Trocknen der ersten und der zweiten lösemittelbasierten Klebstoffzubereitung, um im Wesentlichen alles Lösemittel aus der ersten und der zweiten lösemittelbasierten Klebstoffzubereitung zu entfernen.

13. Verfahren nach Anspruch 9, wobei eines des Folgenden zutrifft,
a) das Druckunterkissen ist ein Druckschaumunterkissen, das Verfahren weiterhin Folgendes umfassend:
vor Beschichten der ersten und der zweiten druckempfindlichen Klebeschicht (728), Behandeln der ersten und/oder der zweiten Oberfläche (730) des Druckschaumunterkissenmaterials mit einem Prozess, der aus der Gruppe ausgewählt ist, bestehend aus einer Koronaentladungsbehandlung, einer Plasmabehandlung und einer Flammbehandlung;
b) Beschichten der ersten druckempfindlichen Klebeschicht (708), das Aufbringen einer ersten lösemittelbasierten Klebstoffzubereitung auf die erste Oberfläche (710) des Druckunterkissenmaterials (702) bei einer Temperatur von weniger als etwa 50 Grad Celsius umfasst, und nachfolgend Trocknen der ersten lösemittelbasierten Klebstoffzubereitung in einem Lufttrockner (740) bei einer Temperatur von weniger als etwa 50 Grad Celsius;
c) das Verfahren weiterhin Folgendes umfassend:
Aufbringen einer Trennfolie (790) auf die zweite druckempfindliche Klebeschicht (728), wobei gegebenenfalls das Druckunterkissenmaterial (702) eine Dicke ungefähr in dem Bereich von 0,254 mm (10 Mil) bis 1,016 mm (40 Mil) aufweist;
d) Beschichten der zweiten druckempfindlichen Klebeschicht (728) auf der zweiten entgegengesetzten Oberfläche des Druckunterkissenmaterials (702), das Aufbringen der zweiten druckempfindlichen Klebeschicht (728) auf eine Trennfolie (790) und dann Aufbringen der zweiten druckempfindlichen Klebeschicht (728) auf die zweite entgegengesetzte Oberfläche des Druckunterkissens durch die Trennfolie (790) umfasst; und
e) Kleben der ersten Oberfläche (710) des Druckunterkissenmaterials (702) direkt auf die Rückfläche des Polierkissens, das Kleben der ersten Oberfläche (710) des Druckunterkissenmaterials (702) direkt auf die Rückfläche eines Polierkissens aus duroplastischem Polyurethan umfasst.

14. Unterkissen für einen Polierkissenstapel, das Unterkissen Folgendes umfassend:
ein Druckunterkissenmaterial (702) mit einer ersten Oberfläche (710) und einer zweiten entgegengesetzten Oberfläche;
eine erste druckempfindliche Klebeschicht (708), die auf der ersten Oberfläche (710) des Druckunterkissenmaterials (702) beschichtet ist, und
eine erste Trennfolie (790), die auf der ersten druckempfindlichen Klebeschicht (708) angeordnet ist;
und
eine zweite druckempfindliche Klebeschicht (728), die auf der zweiten Oberfläche (730) des Druckunterkissenmaterials (702) beschichtet ist,
**dadurch gekennzeichnet, dass** die erste Oberfläche (710) des Druckunterkissenmaterials (702) eine Oberflächenenergie ungefähr in dem Bereich von 0,3 bis 0,4 Pa (30 bis 40 dyn/cm²) aufweist, und wobei die erste Oberfläche (710) des Druckunterkissenmaterials (702) eine Oberflächenrauhigkeit von mindestens 3 Mikron aufweist und eine Gesamtoberfläche aufweist und die erste druckempfindliche Klebeschicht (708) in direktem Kontakt mit mindestens 90 % der Gesamtoberfläche der ersten Oberfläche (710) des Druckunterkissenmaterials (702) steht.

15. Unterkissen nach Anspruch 14, wobei eines des Folgenden zutrifft,
a) das Unterkissen umfasst weiterhin Folgendes:
eine zweite Trennfolie (790), die auf der zweiten druckempfindlichen Klebeschicht (728) angeordnet ist;
b) die erste druckempfindliche Klebeschicht (708) ist eine entfernbare druckempfindliche Klebeschicht, und wobei die zweite druckempfindliche Klebeschicht (728) eine permanente druckempfindliche Klebeschicht ist, wobei gegebenenfalls die permanente druckempfindliche Klebeschicht zum Koppeln mit einer Rückfläche eines Polierkissens dient und wobei die entfernbare druckempfindliche Klebeschicht zum Koppeln des Unterkissens mit einer Platte einer chemisch-mechanischen Poliervorrichtung dient;
c) die zweite druckempfindliche Klebeschicht (728) weist eine Ablösefestigkeit von mehr als ungefähr 788,07 N/m (4,5 Pfund pro Zoll) bei 25 Grad Celsius auf, und wobei die erste druckempfindliche Klebeschicht (708) eine Ablösefestigkeit von weniger als ungefähr 700,50 N/m (4 Pfund pro Zoll) bei 25 Grad Celsius aufweist;
d) das Druckunterkissenmaterial (702) ist ein Druckschaumunterkissenmaterial, das ein Material umfasst, das aus der Gruppe ausgewählt ist, bestehend aus einem geschlossenzelligen Ethylenvinylacetat-Schaummaterial, einem geschlossenzelligen Polyethylen-Schaummaterial und einem überwiegend geschlossenzelligen Polyurethan-Schaummaterial;
e) das Druckunterkissenmaterial (702) ist ein Druckschaumunterkissenmaterial, und wobei die zweite Oberfläche (730) des Druckschaumunterkissenmaterials eine Oberflächenenergie ungefähr im Bereich von 0,3 bis 0,4 Pa (30 bis 40 dyn/cm²) aufweist;
f) die zweite druckempfindliche Klebeschicht (728) umfasst ein erstes Material, das aus der Gruppe ausgewählt ist, bestehend aus einem Acryl-Material, einem Gummi, Ethylenvinylacetat, einem Silikon-Material und einem Blockcopolymer, und wobei die erste druckempfindliche Klebeschicht (708) ein zweites Material umfasst, das aus der Gruppe ausgewählt ist, bestehend aus einem Acryl-Material, einem Gummi, Ethylenvinylacetat, einem Silikon-Material und einem Blockcopolymer; und
g) die zweite Oberfläche (730) des Druckunterkissenmaterials (702) weist eine Oberflächenrauhigkeit von mindestens 3 Mikron auf und weist eine Gesamtoberfläche auf und die zweite druckempfindliche Klebeschicht (728) steht in direktem Kontakt mit mindestens 90 % der Gesamtoberfläche der zweiten Oberfläche (730) des Druckunterkissenmaterials (702) .

## Revendications

1. Empilement de tampon de polissage destiné à polir un substrat, l'empilement de tampon de polissage comprenant :
un tampon de polissage (200, 500) ayant une surface de polissage et une surface arrière ; et
un sous-tampon compressif (202, 550) avec une première surface ayant une première couche d'adhésif sensible à la pression (204, 552) déposée par-dessus, la première surface du sous-tampon compressif (202, 550) étant directement couplée à la surface arrière du tampon de polissage (200, 500) par la première couche d'adhésif sensible à la pression (204, 552),
**caractérisé en ce que** la première surface du sous-tampon compressif (202, 550) a une énergie de surface approximativement dans la plage de 0,3-0,4 Pa (30-40 dyne/cm²) et dans lequel la première surface du sous-tampon compressif (202, 550) a une rugosité de surface d'au moins 3 micromètres et a une superficie totale, et la première couche d'adhésif sensible à la pression (204, 552) est en contact direct avec au moins 90 % de la superficie totale de la première surface du sous-tampon compressif.

2. Empilement de tampon de polissage selon la revendication 1, comprenant en outre :
une deuxième couche d'adhésif sensible à la pression (206, 554) déposée sur une deuxième surface du sous-tampon compressif, la deuxième surface du sous-tampon compressif (202, 550) étant à l'opposé de la première surface.

3. Empilement de tampon de polissage selon la revendication 2, dans lequel la première couche d'adhésif sensible à la pression (204, 552) est une couche d'adhésif sensible à la pression permanente, et dans lequel la deuxième couche d'adhésif sensible à la pression (206, 554) est une couche d'adhésif sensible à la pression amovible.

4. Empilement de tampon de polissage selon la revendication 3, dans lequel la couche d'adhésif sensible à la pression amovible est destinée à coupler l'empilement de tampon de polissage à un plateau (210, 556) d'un appareil de polissage mécanochimique, comprenant en outre :
une doublure détachable (790) disposée sur la couche d'adhésif sensible à la pression amovible.

5. Empilement de tampon de polissage selon la revendication 3, dans lequel la première couche d'adhésif sensible à la pression (204, 552) a une résistance au pelage supérieure à environ 788,07 N/m (4,5 livres par pouce) à 25 degrés Celsius, et dans lequel la deuxième couche d'adhésif sensible à la pression (206, 554) a une résistance au pelage inférieure à environ 700,50 N/m (4 livres par pouce) à 25 degrés Celsius, éventuellement dans lequel la deuxième couche d'adhésif sensible à la pression (206, 554) a une résistance au pelage inférieure à environ 437,81 N/m (2,5 livres par pouce) à 25 degrés Celsius.

6. Empilement de tampon de polissage selon la revendication 1, dans lequel le sous-tampon compressif (202, 550) est un sous-tampon compressif en mousse, éventuellement dans lequel le sous-tampon compressif en mousse comprend un matériau choisi dans le groupe constitué par un matériau en mousse à cellules fermées à base d'éthylène-acétate de vinyle, un matériau en mousse à cellules fermées à base de polyéthylène, et un matériau en mousse principalement à cellules fermées à base de polyuréthane.

7. Empilement de tampon de polissage selon la revendication 1, dans lequel un des énoncés suivants s'applique :
a) le sous-tampon compressif (202, 550) a une épaisseur approximativement dans la plage de 0,254 mm (10 mils) à 1,016 mm (40 mils) ;
b) la première couche d'adhésif sensible à la pression (204, 552) comprend un matériau choisi dans le groupe constitué par un matériau acrylique, un caoutchouc, l'éthylène-acétate de vinyle, un matériau à base de silicone, et un copolymère séquencé ; et
c) le tampon de polissage (200, 500) comprend un matériau en polyuréthane thermodurci.

8. Empilement de tampon de polissage selon la revendication 2, dans lequel le tampon de polissage (200, 500) comprend une couche de polissage (502) couplée à une couche de base (502), et dans lequel la surface arrière du tampon de polissage (200, 500) est une surface de la couche de base (502).

9. Procédé de fabrication d'un empilement de tampon de polissage destiné à polir un substrat, le procédé comprenant :
le dépôt d'une première couche d'adhésif sensible à la pression (708) sur une première surface (710) d'un matériau de sous-tampon compressif (702) ;
le dépôt d'une deuxième couche d'adhésif sensible à la pression (728) sur une deuxième surface, opposée (730) du matériau de sous-tampon compressif (702) ; et
l'adhésion de la première surface (710) du matériau de sous-tampon compressif (702) directement à une surface arrière d'un tampon de polissage par la première couche d'adhésif sensible à la pression (708) ;
**caractérisé en ce que** la première surface (710) du matériau de sous-tampon compressif (702) a une énergie de surface approximativement dans la plage de 0,3-0,4 Pa (30-40 dyne/cm²) et dans lequel la première surface (710) du matériau de sous-tampon compressif (702) a une rugosité de surface d'au moins 3 micromètres et a une superficie totale, et la première couche d'adhésif sensible à la pression (708) est en contact direct avec au moins 90 % de la superficie totale de la première surface (710) du matériau de sous-tampon compressif (702) .

10. Procédé selon la revendication 9, dans lequel le dépôt de la première couche d'adhésif sensible à la pression (708) comprend le dépôt d'une couche d'adhésif sensible à la pression permanente, et dans lequel le dépôt de la deuxième couche d'adhésif sensible à la pression (728) comprend le dépôt d'une couche d'adhésif sensible à la pression amovible.

11. Procédé selon la revendication 9, dans lequel le dépôt de la première couche d'adhésif sensible à la pression (708) comprend le versement puis l'étalement d'une première formulation d'adhésif à base de solvant sur la première surface (710) du matériau de sous-tampon compressif (702), et dans lequel le dépôt de la deuxième couche d'adhésif sensible à la pression (728) comprend le versement puis l'étalement d'une deuxième formulation d'adhésif à base de solvant sur la deuxième surface (730) du matériau de sous-tampon compressif (702).

12. Procédé selon la revendication 11, dans lequel un des énoncés suivants s'applique :
a) le versement puis l'étalement de la première formulation d'adhésif à base de solvant sur la première surface (710) du matériau de sous-tampon compressif (702) sont effectués avant le versement puis l'étalement de la deuxième formulation d'adhésif à base de solvant sur la deuxième surface (730) du matériau de sous-tampon compressif (702) ;
b) le versement puis l'étalement de la première formulation d'adhésif à base de solvant sur la première surface (710) du matériau de sous-tampon compressif (702) sont effectués après le versement puis l'étalement de la deuxième formulation d'adhésif à base de solvant sur la deuxième surface (730) du matériau de sous-tampon compressif (702) ; et
c) le procédé comprenant en outre :
après le versement puis l'étalement de la première formulation d'adhésif à base de solvant sur la première surface (710) du matériau de sous-tampon compressif (702) et le versement puis l'étalement de la deuxième formulation d'adhésif à base de solvant sur la deuxième surface (730) du matériau de sous-tampon compressif (702), le séchage des première et deuxième formulations d'adhésif à base de solvant pour retirer pratiquement tout le solvant des première et deuxième formulations d'adhésif à base de solvant.

13. Procédé selon la revendication 9, dans lequel un des énoncés suivants s'applique :
a) le sous-tampon compressif est un sous-tampon compressif en mousse, le procédé comprenant en outre :
avant le dépôt des première et deuxième couches d'adhésif sensible à la pression (728), le traitement d'au moins une des première et deuxième surfaces (730) du matériau de sous-tampon compressif en mousse par une opération choisie dans le groupe constitué par un traitement par décharge corona, un traitement par plasma, et un traitement à la flamme ;
b) le dépôt de la première couche d'adhésif sensible à la pression (708) comprend l'application d'une première formulation d'adhésif à base de solvant sur la première surface (710) du matériau de sous-tampon compressif (702) à une température inférieure à environ 50 degrés Celsius, puis le séchage de la première formulation d'adhésif à base de solvant dans un séchoir à air (740) à une température inférieure à environ 50 degrés Celsius ;
c) le procédé comprenant en outre :
l'application d'une doublure détachable (790) à la deuxième couche d'adhésif sensible à la pression (728), éventuellement dans lequel le matériau de sous-tampon compressif (702) a une épaisseur approximativement dans la plage de 0,254 mm (10 mils) à 1,016 mm (40 mils) ;
d) le dépôt de la deuxième couche d'adhésif sensible à la pression (728) sur la deuxième surface, opposée du matériau de sous-tampon compressif (702) comprend l'application de la deuxième couche d'adhésif sensible à la pression (728) à une doublure détachable (790) puis l'application de la deuxième couche d'adhésif sensible à la pression (728) à la deuxième surface, opposée du sous-tampon compressif par la doublure détachable (790) ; et
e) l'adhésion de la première surface (710) du matériau de sous-tampon compressif (702) directement à la surface arrière du tampon de polissage comprend l'adhésion de la première surface (710) du matériau de sous-tampon compressif (702) directement à la surface arrière d'un tampon de polissage en polyuréthane thermodurci.

14. Sous-tampon pour un empilement de tampon de polissage, le sous-tampon comprenant :
un matériau de sous-tampon compressif (702) ayant une première surface (710) et une deuxième surface, opposée ;
une première couche d'adhésif sensible à la pression (708) déposée sur la première surface (710) du matériau de sous-tampon compressif (702), et une première doublure détachable (790) disposée sur la première couche d'adhésif sensible à la pression (708) ; et
une deuxième couche d'adhésif sensible à la pression (728) sur la deuxième surface (730) du matériau de sous-tampon compressif (702),
**caractérisé en ce que** la première surface (710) du matériau de sous-tampon compressif (702) a une énergie de surface approximativement dans la plage de 0,3-0,4 Pa (30-40 dyne/cm²) et dans lequel la première surface (710) du matériau de sous-tampon compressif (702) a une rugosité de surface d'au moins 3 micromètres et a une superficie totale, et la première couche d'adhésif sensible à la pression (708) est en contact direct avec au moins 90 % de la superficie totale de la première surface (710) du matériau de sous-tampon compressif (702) .

15. Sous-tampon selon la revendication 14, dans lequel un des énoncés suivants s'applique :
a) le sous-tampon comprenant en outre :
une deuxième doublure détachable (790) disposée sur la deuxième couche d'adhésif sensible à la pression (728) ;
b) la première couche d'adhésif sensible à la pression (708) est une couche d'adhésif sensible à la pression amovible, et dans lequel la deuxième couche d'adhésif sensible à la pression (728) est une couche d'adhésif sensible à la pression permanente, éventuellement dans lequel la couche d'adhésif sensible à la pression permanente est destinée à se coupler à une surface arrière d'un tampon de polissage, et dans lequel la couche d'adhésif sensible à la pression amovible est destinée à coupler le sous-tampon à un plateau d'un appareil de polissage mécanochimique ;
c) la deuxième couche d'adhésif sensible à la pression (728) a une résistance au pelage supérieure à environ 788,07 N/m (4,5 livres par pouce) à 25 degrés Celsius, et dans lequel la première couche d'adhésif sensible à la pression (708) a une résistance au pelage inférieure à environ 700,50 N/m (4 livres par pouce) à 25 degrés Celsius ;
d) le matériau de sous-tampon compressif (702) est un matériau de sous-tampon compressif en mousse comprenant un matériau choisi dans le groupe constitué par un matériau en mousse à cellules fermées à base d'éthylène-acétate de vinyle, un matériau en mousse à cellules fermées à base de polyéthylène, et un matériau en mousse principalement à cellules fermées à base de polyuréthane ;
e) le matériau de sous-tampon compressif (702) est un matériau de sous-tampon compressif en mousse, et dans lequel la deuxième surface (730) du matériau de sous-tampon compressif en mousse a une énergie de surface approximativement dans la plage de 0,3-0,4 Pa (30-40 dyne/cm²) ;
f) la deuxième couche d'adhésif sensible à la pression (728) comprend un premier matériau choisi dans le groupe constitué par un matériau acrylique, un caoutchouc, l'éthylène-acétate de vinyle, un matériau à base de silicone et un copolymère séquencé, et dans lequel la première couche d'adhésif sensible à la pression (708) comprend un deuxième matériau choisi dans le groupe constitué par un matériau acrylique, un caoutchouc, l'éthylène-acétate de vinyle, un matériau à base de silicone, et un copolymère séquencé ; et
g) la deuxième surface (730) du matériau de sous-tampon compressif (702) a une rugosité de surface d'au moins 3 micromètres et a une superficie totale, et la deuxième couche d'adhésif sensible à la pression (728) est en contact direct avec au moins 90 % de la superficie totale de la deuxième surface (730) du matériau de sous-tampon compressif (702).
